# DEMANDE DE BREVET EUROPEEN

(11) **EP 4 800 491 A1**
(43) Date de publication de la demande: **02.09.2026**
(21) Numéro de dépôt: 25160683.6
(22) Date de dépôt: 27.02.2025
(51) Int. Cl.: G04B 39/00, C30B 29/20, G04D 3/06

(54) **PROCÉDÉ DE FABRICATION D'UN ÉLÉMENT HORLOGER EN SAPHIR ET ÉLÉMENT HORLOGER**

(71) Demandeur: ROLEX SA, 1211 Genève 26 (CH)
(72) Inventeur: Donze, Damien, 2345 Les Breuleux (CH); Junod, Benoît, 74250 Peillonnex (FR); Sémoroz, Alain, 1006 Lausanne (CH)
(74) Mandataire: Moinas & Savoye SARL

(57) **Abrégé**

Procédé de fabrication d'un élément horloger en saphir (100), le procédé comprenant une phase d'usinage, puis une phase de terminaison,
le procédé comprenant en outre une première étape de traitement thermique de détente comprenant un palier à une première température supérieure à 1100°C après la phase d'usinage.

## Description

L'invention concerne un procédé de fabrication d'un élément horloger en saphir. L'invention concerne aussi un élément horloger, notamment un élément horloger obtenu par un tel procédé, en particulier un élément de boîte de pièce d'horlogerie. L'invention concerne encore un mouvement horloger comprenant un tel élément ou une boîte de pièce d'horlogerie comprenant un tel élément horloger. L'invention concerne enfin une pièce d'horlogerie comprenant un tel élément ou un tel mouvement horloger ou une telle boîte de pièce d'horlogerie.

La tenue au choc des glaces de pièces d'horlogerie en saphir est régulièrement sujette à caution car, bien que le saphir soit extrêmement résistant, des chocs accidentels peuvent induire des ruptures. De plus, des égrisures peuvent apparaître sur leur pourtour, notamment lorsque ces glaces sont prévues pour surplomber une lunette de boîte de montre et sont donc sujettes à subir des chocs lors du porter quotidien de la montre. Ces risques sont d'autant plus avérés pour des glaces creusées dont les épaisseurs sont minimisées et/ou dont les sections comprennent des zones de moindre résistance mécanique.

Conventionnellement, les glaces en saphir non-colorées sont obtenues à l'issue d'un procédé comprenant trois phases usuelles :
- une première phase de préparage P1, à l'issue de laquelle une ébauche de glace est obtenue à partir d'une boule ou d'une plaque en saphir,
- une deuxième phase d'usinage P2, à l'issue de laquelle une glace non finalisée est obtenue à partir de l'ébauche de glace,
- une troisième phase de terminaison P3, à l'issue de laquelle la glace définitive est obtenue.

En ce qui concerne plus précisément les glaces de montre, de manière usuelle, leur épaisseur est dimensionnée pour résister aux diverses sollicitations externes telles que la pression et les chocs. Le dimensionnement d'une boîte est donc notamment dicté par le dimensionnement de la glace. Plus particulièrement, plus une glace est épaisse, plus elle est résistante aux diverses sollicitations externes, ce qui induit en contrepartie une boîte particulièrement épaisse. Un affinement de la glace, et donc de la boîte, requiert ainsi une redéfinition du mode d'assemblage de la glace, ainsi qu'un procédé de fabrication permettant l'obtention d'une glace suffisamment résistante aux diverses sollicitations.

Le document CH718724B1 décrit une boîte de montre permettant l'assemblage d'une glace fine et rigide réalisée dans un matériau dur. La boîte de montre comprend un cran de glace accueillant un joint d'étanchéité destiné à maintenir et à garantir l'étanchéité de la glace. Le cran de glace comprend au fond une gorge qui permet l'insertion d'un joint dont les dimensions sont adaptées au chassage d'une glace fine. Cette gorge permet d'éviter que le joint ne s'enroule sur lui-même lors du chassage et, pour des raisons esthétiques, qu'il ne dépasse au-dessus de la glace après assemblage.

Le but de l'invention est de fournir un procédé de fabrication permettant l'obtention d'un élément horloger en saphir, notamment d'une glace en saphir, particulièrement résistant aux sollicitations externes. En particulier, l'invention propose un procédé de fabrication améliorant la fiabilité des éléments horlogers, notamment des glaces, en saphir. L'invention propose aussi un assemblage optimisé d'une glace, notamment dans le cadre d'une boîte de montre particulièrement mince.

Selon un premier aspect de l'invention, des objets sont définis par les propositions qui suivent :
1. Procédé de fabrication d'un élément horloger en saphir (100), le procédé comprenant une phase d'usinage, puis une phase de terminaison,
   le procédé comprenant en outre une première étape de traitement thermique de détente comprenant un premier palier à une première température supérieure à 1100°C après la phase d'usinage.
2. Procédé de fabrication selon la proposition 1, caractérisé :
   - en ce que la première température est supérieure à 1600°C, et/ou
   - en ce que la première température est inférieure à 2000°C ou inférieure à 1950°C ou inférieure à 1800°C ou inférieure à 1750°C.
3. Procédé de fabrication selon l'une des propositions 1 et 2, caractérisé en ce que la première étape de traitement thermique de détente a lieu entre les phases d'usinage et de terminaison.
4. Procédé de fabrication selon l'une des propositions 1 et 2, caractérisé en ce que la première étape de traitement thermique de détente a lieu entre deux étapes de polissage successives de la phase de terminaison.
5. Procédé de fabrication selon l'une des propositions 1 à 4, caractérisé en ce que le procédé de fabrication comprend une deuxième étape de traitement thermique de détente, comprenant un palier à une température comprise entre 1000°C et 1200°C, notamment à une température d'environ 1050°C.
6. Procédé de fabrication selon la proposition 5, caractérisé en ce que la deuxième étape de traitement thermique de détente, a lieu entre les phases d'usinage et de terminaison.
7. Procédé de fabrication selon l'une des propositions 1 à 6, caractérisé en ce que le procédé de fabrication comprend une troisième étape de traitement thermique de détente, comprenant un palier à une température comprise entre 1000°C et 1200°C, notamment à une température d'environ 1050°C, ayant lieu entre deux étapes d'usinage successives de la phase d'usinage.
8. Procédé de fabrication selon l'une des propositions 1 à 7, caractérisé en ce que le procédé de fabrication comprend :
   - une phase de préparage antérieure à la phase d'usinage, et
   - une quatrième étape de traitement thermique de détente, comprenant un palier à une température comprise entre 1000°C et 1200°C, notamment à une température d'environ 1050°C, ayant lieu entre la phase de préparage et la phase d'usinage.
9. Procédé de fabrication selon l'une des propositions 1 à 8, caractérisé en ce que le premier palier à la première température a une durée comprise entre 2 heures et 15 heures, typiquement 5 heures.
10. Procédé de fabrication selon l'une des propositions 1 à 9, caractérisé en ce qu'une ou plusieurs ou toutes les deuxième, troisième et quatrième étapes comprend ou comprennent un palier à une température d'environ 1050°C, le palier ayant une durée comprise entre 2 heures et 15 heures, typiquement 5 heures.
11. Procédé de fabrication selon l'une des propositions 1 à 10, caractérisé en ce qu'une ou plusieurs ou toutes les première, deuxième, troisième et quatrième étapes sont réalisées sous atmosphère contrôlée, notamment :
   - sous vide, ou
   - sous gaz neutre ou inerte, ou
   - sous atmosphère réductrice ou désoxydante, avec par exemple un gaz réducteur tel qu'un mélange H2-N2, ou avec par exemple un gaz neutre ou inerte combiné à des éléments chauffants en graphite qui vont produire du monoxyde de carbone, ou
   - sous atmosphère oxydante, par exemple sous air.
12. Procédé de fabrication selon l'une des propositions 1 à 11, caractérisé en ce que l'élément horloger (100) est une glace et la phase d'usinage comprend la réalisation d'une creusure dans la glace et/ou en ce que l'élément horloger (100) est réalisé en saphir incolore ou en saphir non-coloré.
13. Procédé de fabrication selon l'une des propositions 1 à 11, caractérisé en ce que l'élément horloger est un élément d'habillage ou élément de mouvement horloger, en particulier :
   - une glace, notamment prévue pour être rapportée sur une carrure ou sur un fond, ou
   - un fond, ou
   - une couronne, ou
   - une lunette, ou
   - un disque de lunette, ou
   - une carrure, ou
   - une carrure incluant une glace, c'est-à-dire que la carrure forme une glace ou la carrure est formée d'un seul tenant avec la glace, ou
   - un disque indicateur, notamment un disque de calendrier.
14. Elément horloger en saphir (100), notamment en saphir incolore ou en saphir non-coloré, obtenu par la mise en œuvre du procédé de fabrication selon l'une des propositions 1 à 13.
15. Boîte de pièce d'horlogerie (400) comprenant un élément horloger en saphir (100) selon la proposition 14.
16. Mouvement horloger (150) comprenant un élément horloger en saphir (100) selon la proposition 14.
17. Pièce d'horlogerie (300), notamment montre-bracelet, comprenant :
   - un élément horloger en saphir (100) selon la proposition 14, et/ou
   - une boîte de pièce d'horlogerie (400) selon la proposition 15, et/ou
   - un mouvement horloger (150) selon la proposition 16.

Selon un deuxième aspect de l'invention, des objets sont définis par les propositions qui suivent :
18. Elément (100) de boîte (400) de pièce d'horlogerie (300) de type glace, l'élément comprenant :
   - un côté extérieur (100a) destiné à être au contact de l'environnement extérieur,
   - un côté intérieur (100b) destiné à être au contact du volume interne de la boîte de pièce d'horlogerie, et
   - un bord latéral (100d) reliant les côtés extérieur et intérieur, le bord latéral (100d) comprenant une rainure (1c), le côté intérieur comprenant une creusure (1d) de sorte que le bord latéral (100d) comprend une jupe (1f).
19. Elément selon la proposition 18, caractérisé en ce que l'élément (100) est réalisé :
   - en céramique transparente, notamment en céramique polycristalline transparente ou en céramique monocristalline transparente, ou
   - en verre, notamment en verre trempé, ou
   - en saphir.
20. Elément selon l'une des propositions 18 et 19, caractérisé en ce que le bord latéral (100d) comprend :
   - d'un premier côté de la rainure (1c), une première portion (1b) destinée à coopérer avec un joint d'étanchéité (2), et
   - d'un deuxième côté de la rainure (1c), une deuxième portion (1a), d'une plus grande dimension, notamment d'un plus grand diamètre, que celle de la première portion (1b).
21. Elément selon l'une des propositions 18 à 20, caractérisé en ce que l'élément est dimensionné pour résister à une pression d'au moins 10 bars appliquée sur le côté extérieur (100a).
22. Elément selon l'une des propositions 18 à 21, caractérisé en ce qu'une première épaisseur (e1) mesurée entre le côté extérieur et le fond de la creusure est comprise entre 1 mm et 1.5 mm, typiquement environ 1.3 mm.
23. Elément selon l'une des propositions 18 à 22, caractérisé en ce qu'une deuxième épaisseur (e2) mesurée entre le fond de la rainure et un flanc de la creusure est comprise entre 0.35 mm et 0.5 mm.
24. Elément selon l'une des propositions 18 à 23, caractérisé en ce qu'une troisième épaisseur (e3) de la jupe est comprise entre 0.4 mm et 0.6 mm.
25. Elément selon la proposition 24 et selon la proposition 22, caractérisé en ce que le rapport de la troisième épaisseur (e3) sur la première épaisseur (e1) est inférieur à 1, voire compris entre 0.3 et 0.5, typiquement 0.35 ou 0.42.
26. Elément selon l'une des propositions 18 à 25, caractérisé en ce qu'une profondeur (e4) de la creusure (1d) est comprise entre 0.2 mm et 0.6 mm.
27. Elément selon l'une des propositions 18 à 26 et selon la proposition 20, caractérisé en ce qu'une épaisseur (e5) de la première portion (1b) est comprise entre 0.3 mm et 0.4 mm, typiquement 0.38 mm.
28. Elément selon la proposition 26 et selon la proposition 27, caractérisé en ce que le rapport de l'épaisseur (e5) sur la profondeur (e4) de la creusure (1d) est inférieur à 1, voire compris entre 0.7 et 0.8, typiquement 0.76.
29. Elément selon l'une des propositions 18 à 28, caractérisé en ce qu'il comprend un congé de raccordement (1g) entre le fond de la creusure et la jupe, le congé de raccordement (1g) présentant un rayon compris entre 0.1 mm et 0.7 mm, typiquement 0.3 mm ou 0.6 mm.
30. Elément selon l'une des propositions 18 à 29, caractérisé en ce que l'élément est obtenu par le procédé selon l'une des propositions 1 à 13.
31. Boîte de pièce d'horlogerie (400) comprenant un élément horloger (100) selon l'une des propositions 18 à 30.
32. Boîte de pièce d'horlogerie (400) selon la proposition 31, caractérisée en ce qu'elle comprend une lunette (4) et un joint d'étanchéité (2) disposé entre la lunette et l'élément horloger (100).
33. Boîte de pièce d'horlogerie (400) selon la proposition 31, caractérisée en ce qu'elle comprend un fond et un joint d'étanchéité (2) disposé entre le fond et l'élément (100).
34. Boîte de pièce d'horlogerie (400) selon l'une des propositions 31 à 33, caractérisée en ce que le joint d'étanchéité (2) est réalisé :
   - en nylon ou polyamide, tel qu'un polyamide 6 ou 6.6 ou un Zytel^{®} ou un Grilamid^{®}, ou
   - en élastomère thermoplastique ou en copolyester élastomère thermoplastique tel que l'Hytrel^{®}.
35. Boîte de pièce d'horlogerie (400) selon l'une des propositions 31 à 34, caractérisée en ce qu'elle comprend une carrure (3) et en ce que la rainure (1c) coopère avec une saillie (2a) du joint d'étanchéité (2) de façon à ancrer l'élément horloger (100), notamment à la lunette (4) et/ou à la carrure (3) et/ou au fond.
36. Boîte de pièce d'horlogerie (400) selon l'une des propositions 31 à 35, caractérisée en ce qu'elle comprend une carrure (3) présentant une dimension d'ouverture (d2), notamment un diamètre d'ouverture (d2), et en ce que la dimension de fond de creusure, notamment le diamètre (d1) de fond de creusure, est supérieure ou égale à la dimension d'ouverture (d2), notamment au diamètre d'ouverture (d2).
37. Pièce d'horlogerie (300), notamment montre-bracelet, comprenant :
   - un élément horloger (100) selon l'une des propositions 18 à 30, et/ou
   - une boîte de pièce d'horlogerie (400) selon l'une des propositions 31 à 36.

Les figures représentent, à titre d'exemples, trois modes de réalisation d'une pièce d'horlogerie selon l'invention.

La figure 1 illustre un premier mode de réalisation d'une pièce d'horlogerie selon l'invention.

La figure 2 est un graphique illustrant des effets du procédé de fabrication selon l'invention sur des caractéristiques d'une glace en saphir selon le premier mode de réalisation.

La figure 3 illustre un deuxième mode de réalisation d'une pièce d'horlogerie selon l'invention.

La figure 4 est un graphique illustrant des effets du procédé de fabrication selon l'invention sur des caractéristiques d'une glace en saphir selon le deuxième mode de réalisation.

La figure 5 est un ordinogramme d'un premier mode d'exécution du procédé de fabrication selon l'invention.

La figure 6 est un ordinogramme d'un deuxième mode d'exécution du procédé de fabrication selon l'invention.

La figure 7 est un ordinogramme d'un troisième mode d'exécution du procédé de fabrication selon l'invention.

La figure 8 est un ordinogramme d'un quatrième mode d'exécution du procédé de fabrication selon l'invention.

La figure 9 est un ordinogramme d'un cinquième mode d'exécution du procédé de fabrication selon l'invention.

La figure 10 est une vue de détail du deuxième mode de réalisation d'une pièce d'horlogerie selon l'invention.

La figure 11 est une vue de détail d'un troisième mode de réalisation d'une pièce d'horlogerie selon l'invention.

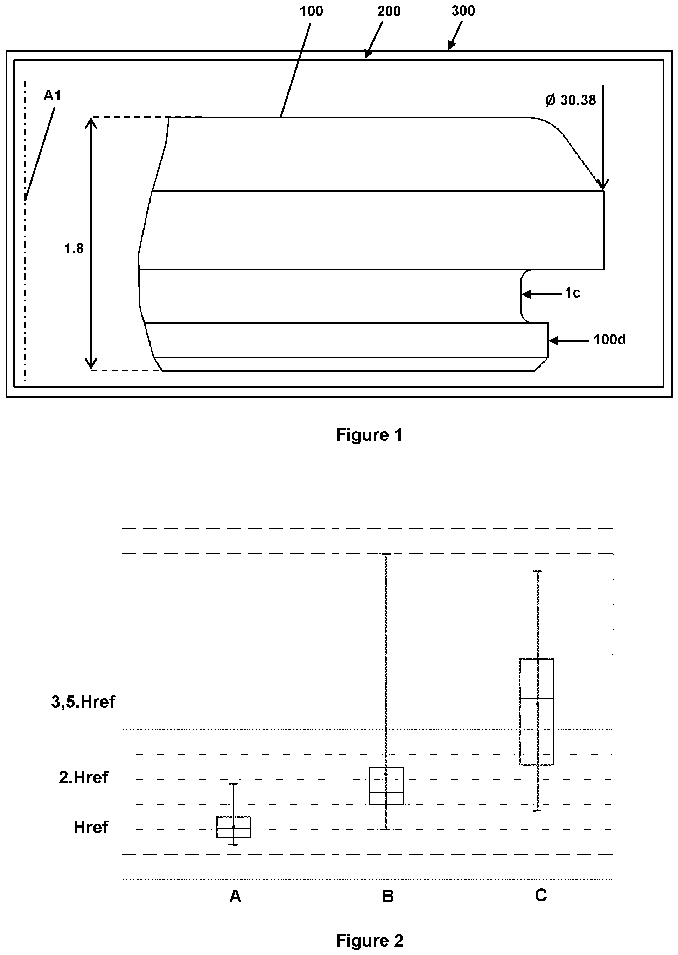

Trois modes de réalisation d'une pièce d'horlogerie 300 selon l'invention sont décrits ci-après en référence aux figures 1, 3, 10 et 11. La pièce d'horlogerie est par exemple une montre, notamment une montre bracelet. La pièce d'horlogerie comprend un mouvement d'horlogerie. Le mouvement horloger 200 peut être :
- un mouvement mécanique, notamment un mouvement automatique, ou
- un mouvement électronique, ou
- un mouvement hybride.

La pièce d'horlogerie 300 comprend encore une boîte 400 destinée à recevoir le mouvement horloger 200 et à le protéger de l'environnement extérieur.

La boîte 400 comprend :
- une carrure 3,
- une glace 100,
- un joint d'étanchéité 2, et
- éventuellement, une lunette 4, par exemple une lunette ou une portion de lunette fixe relativement à la carrure 3,
- éventuellement, un fond rapporté sur la carrure ou réalisé d'un seul tenant avec la carrure.

La pièce d'horlogerie 300, notamment la boîte 400 ou le mouvement horloger 200, comprend un élément horloger transparent 100, en particulier :
- la glace, notamment prévue pour être rapportée sur la carrure ou sur le fond, ou
- le fond, ou
- une couronne, ou
- une lunette, ou
- un disque de lunette, ou
- une carrure, ou
- une carrure incluant une glace, c'est-à-dire que la carrure forme une glace ou la carrure est formée d'un seul tenant avec la glace, ou
- un disque indicateur, notamment un disque de calendrier.

L'élément horloger 100 peut donc être un élément d'habillage ou un élément de mouvement horloger.

L'élément horloger 100 peut être réalisé :
- en céramique transparente, notamment en céramique polycristalline transparente ou en céramique monocristalline transparente comme le YAG par exemple, ou
- en verre, notamment en verre trempé, ou
- en saphir.

L'élément horloger 100 comprend un axe A1 s'étendant parallèlement à l'épaisseur (soit la plus petite dimension) de l'élément horloger. L'axe A1 est de préférence centré sur l'élément horloger 100.

Selon les différents modes de réalisation, l'élément horloger 100 est de préférence réalisé en saphir et de préférence obtenu par la mise en œuvre d'un mode d'exécution d'un procédé de fabrication comprenant :
- une phase d'usinage, puis
- une phase de terminaison,
le procédé de fabrication de l'élément horloger 100 comprenant en outre une première étape de traitement thermique de détente à une première température supérieure à 1100°C après la phase d'usinage.

La première température est de préférence :
- supérieure à 1600°C, et/ou
- inférieure à 2000°C ou inférieure à 1950°C ou inférieure à 1800°C ou inférieure à 1750°C.

La première étape de traitement thermique de détente peut avoir lieu :
- entre les phases d'usinage et de terminaison, ou
- entre deux étapes de polissage successives de la phase de terminaison.

Les études expérimentales de la Déposante ont notamment montré que l'étape de traitement thermique de détente permet d'obtenir des éléments, en particulier des glaces, qui supportent mieux les chocs accidentels, en particulier les chutes d'une hauteur d'un mètre ou plus, qui peuvent par exemple malencontreusement survenir au moment où le porteur retire sa montre du poignet. En particulier, les études de la Déposante ont montré que l'étape de traitement thermique de détente permet d'augmenter la hauteur de chute à rupture. Dans ces études, un équipement utilisé est un percuteur de type Bélier, comme cela est décrit dans la norme NIHS 91-10 ou ISO 1413. Des boîtes de montre munies de glaces en saphir de différentes géométries ont fait l'objet de deux séries distinctes de tests. Notamment, l'équipement mis en œuvre a pour particularité d'être muni d'un sabot en aluminium (et non en bois dur), afin de permettre la casse des glaces et non du sabot. Les boîtes étaient également toutes orientées de la même façon, de sorte que le sabot percute en premier lieu le bord ou le pourtour de la glace.

Une première série de tests porte sur différentes configurations d'une glace circulaire plate, dotée d'une épaisseur de 1.8 mm et d'un diamètre de 30.38 mm (représentée sur la figure 1), et présentant une orientation cristallographique de type A obtenue par procédé de croissance Verneuil. La glace comporte par ailleurs une gorge ou une rainure annulaire 1c afin de permettre son assemblage sur la carrure, par l'intermédiaire d'un joint d'étanchéité prévu pour venir se loger dans cette gorge.

Les différentes configurations comprennent :
- un premier lot A de référence de 100 glaces obtenues par un procédé de fabrication incluant un traitement thermique de détente TT1 à une température de 1100°C, effectué entre une deuxième phase d'usinage P2 et une troisième phase de terminaison P3,
- un deuxième lot B de 100 glaces ayant subi un traitement thermique de détente additionnel à 1650°C effectué lors d'une troisième phase de terminaison (additionnel à un traitement thermique de détente TT1 à une température de 1100°C, effectué entre la deuxième phase d'usinage P2 et la troisième phase de terminaison P3), et
- un troisième lot C de 100 glaces ayant subi un seul traitement thermique de détente à 1920°C effectué entre la deuxième phase d'usinage P2 et la troisième phase de terminaison P3 (en lieu et place du traitement thermique de détente à une température de 1100°C, effectué entre la deuxième phase d'usinage P2 et la troisième phase de terminaison P3).

En pratique :
- pour le deuxième lot B, le traitement thermique de détente est effectué sous air, et le palier à 1650°C dure 5 heures,
- pour le troisième lot C, le traitement thermique de détente est effectué sous gaz neutre ou inerte, en particulier atmosphère d'argon, et le palier à 1920°C dure également 5 heures.

La figure 2 met en évidence les gains induits par les traitements thermiques effectués sur les lots B et C, le traitement thermique effectué à plus haute température (en lieu et place du traitement thermique de détente TT1 préalable à une température de 1100°C), à savoir celui du troisième lot C, étant le plus favorable, avec une hauteur moyenne de casse environ 3 fois et demie supérieure à une hauteur moyenne de référence Href mesurée pour le lot A. Le deuxième lot B donne également de bons résultats avec une hauteur moyenne de casse de l'ordre de 2 fois la hauteur moyenne de référence Href. Sur le graphique, les extrémités des segments verticaux représentent les valeurs extrêmes obtenues. Les boîtes à moustaches (ou boîtes de Tuckey) représentent donc :
- les valeurs extrêmes (extrémités des segments verticaux),
- les valeurs médianes (segments horizontaux dans les rectangles),
- les premiers quartiles (côtés inférieurs des rectangles), et
- les troisièmes quartiles (côtés supérieurs des rectangles) des glaces testées.

Le point dans chaque rectangle représente la valeur moyenne.

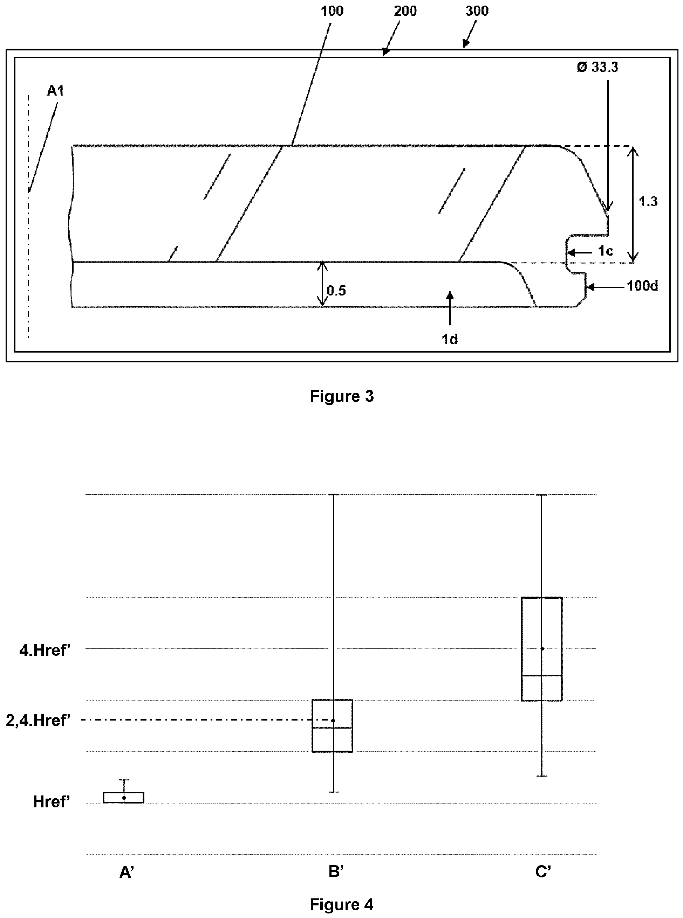

La deuxième série de tests porte sur différentes configurations d'une glace creusée, à savoir munie d'une creusure 1d (comme représenté sur la figure 3), qui est dotée d'une épaisseur de 1.3 mm en son centre et d'un diamètre de 33.3 mm. La glace présente une orientation cristallographique de type A obtenue par procédé de croissance Verneuil. La glace comporte par ailleurs une gorge annulaire ou une rainure 1c, formée au niveau de son pourtour 100d ou bord latéral 100d, afin de permettre son assemblage sur la carrure par l'intermédiaire d'un joint d'étanchéité prévu pour venir se loger dans cette même gorge ou rainure.

Les différentes configurations comprennent :
- un premier lot de référence A' de 20 glaces obtenues par un procédé de fabrication incluant un traitement thermique de détente TT1 à une température de 1100°C, effectué entre la deuxième phase d'usinage P2 et la troisième phase de terminaison P3,
- un deuxième lot B' de 20 glaces ayant subi un traitement thermique de détente additionnel à 1600°C lors de la troisième phase de terminaison (additionnel au traitement thermique de détente TT1 à une température de 1100°C, effectué entre la deuxième phase d'usinage P2 et la troisième phase de terminaison P3), et
- un troisième lot C' de 20 glaces ayant subi un traitement thermique de détente additionnel à 1750°C effectué lors de la troisième phase de terminaison (additionnel au traitement thermique de détente TT1 à une température de 1100°C, effectué entre la deuxième phase d'usinage P2 et la troisième phase de terminaison P3).

Cette deuxième série de tests montre à nouveau que le traitement thermique effectué à plus haute température, à savoir celui du troisième lot C', est le plus favorable, avec une hauteur moyenne de casse de l'ordre de 4 fois la hauteur moyenne de casse Href' du premier lot A' de référence comme illustré sur la figure 4. Le deuxième lot B' donne également de bons résultats avec une hauteur moyenne de casse de l'ordre de 2,4 fois la hauteur moyenne de référence Href'.

Ces deux séries de tests montrent là aussi l'intérêt d'un traitement thermique de détente effectué en fin de gamme, à très haute température, que celui-ci vienne ou non en complément d'un traitement thermique de détente effectué à une température de 1100°C ou inférieure à 1100°C.

Le procédé de fabrication de l'élément horloger 100 de type glace comprend trois phases :
- une première phase de préparage P1, à l'issue de laquelle une ébauche de glace est obtenue à partir d'une boule ou d'une plaque en saphir,
- une deuxième phase d'usinage P2, à l'issue de laquelle une glace non finalisée est obtenue à partir de l'ébauche de glace,
- une troisième phase de terminaison P3, à l'issue de laquelle la glace définitive est obtenue.

Les phases d'usinage P2 et de terminaison P3 se distinguent en ce que la phase d'usinage est une phase d'enlèvement de matière constituée par des étapes d'enlèvement de matière permettant l'obtention au moins partielle de la géométrie de l'élément horloger 100, et en ce que la phase de terminaison est une phase de terminaison constituée par des étapes de terminaison permettant l'obtention au moins partiel de l'état de surface de l'élément horloger 100.

De préférence, la rugosité Ra de la surface visible de l'élément horloger 100 au travers de laquelle sont visibles d'autres éléments d'une pièce d'horlogerie munie de l'élément horloger 100, notamment de la glace 100, est :
- supérieure à 0.2 µm avant la phase de terminaison (et donc avant montage sur la pièce d'horlogerie), et
- inférieure à 0.2 µm après la phase de terminaison (et donc notamment mesurable sur la pièce d'horlogerie).

Alternativement ou complémentairement, la transmission de lumière au travers de la surface visible de l'élément horloger 100, notamment de la glace 100, avant la phase de terminaison est comprise entre 40 et 50% (et donc avant montage sur la pièce d'horlogerie), alors qu'elle est supérieure à 80% après la phase de terminaison.

Quel que soit le mode de réalisation ou la variante, le procédé comprend une première étape de traitement thermique de détente TT1'. Cette première étape de traitement thermique de détente TT1' :
- est effectuée après la deuxième phase d'usinage P2, et
- comprend un palier de température (pendant lequel la température est stable et) supérieure à 1100°C, voire très supérieure à 1100°C, typiquement comprise entre 1600°C et 2000°C.

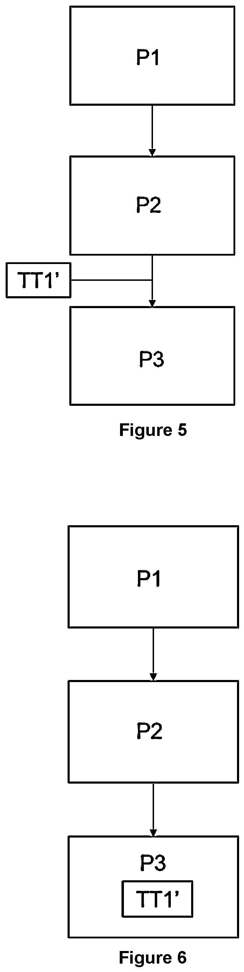

Comme illustré sur la figure 5, dans un premier mode d'exécution du procédé, cette étape peut être effectuée entre la deuxième phase d'usinage P2 et la troisième phase de terminaison P3.

Comme illustré sur la figure 6, dans un deuxième mode d'exécution du procédé, cette étape TT1' peut être effectuée lors de la troisième phase de terminaison P3, à savoir entre deux étapes prenant part à la troisième phase de terminaison.

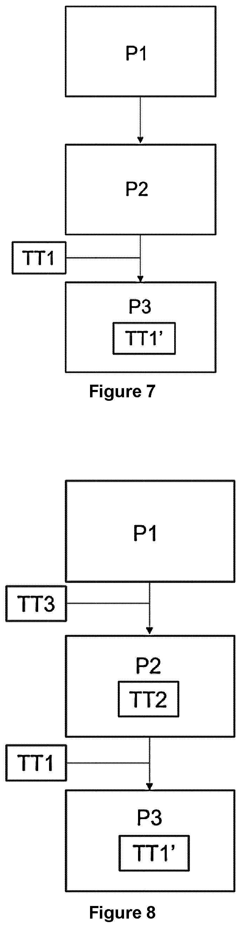

Selon une variante particulière de ce deuxième mode d'exécution illustrée sur la figure 7, l'étape TT1' peut être effectuée en complément d'une deuxième étape TT1 de traitement thermique de détente à une température environ égale à 1050°C ou à une température comprise entre 1000°C et 2000°C et qui peut être effectuée entre la deuxième phase d'usinage P2 et la troisième phase de terminaison P3.

Selon une autre variante particulière de ce deuxième mode d'exécution illustrée sur la figure 8, le procédé comprend deux autres étapes de traitement thermique de détente préalables, par exemple comprenant toutes deux un palier de température à environ 1050°C, notamment entre 1000°C et 1200°C. Il pourrait s'agir :
- d'une étape de traitement thermique TT3 effectuée entre une première phase de préparage P1 et la deuxième phase d'usinage P2, et
- d'une étape de traitement thermique TT2 effectuée lors de la deuxième phase d'usinage P2.

La première étape TT1' de traitement thermique de détente peut être effectuée :
- à une température supérieure à 1100°C, voire très supérieure à 1100°C, notamment supérieure à 1600°C, et/ou
- à une température inférieure à 2000°C ou inférieure à 1950°C ou inférieure à 1800°C ou inférieure à 1750°C.

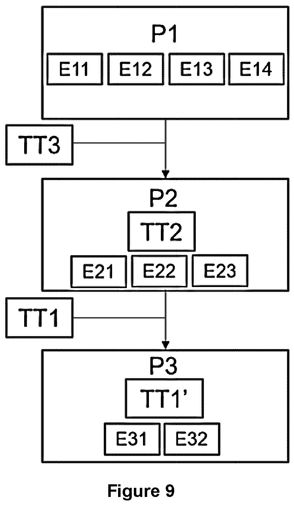

Comme illustré sur la figure 9, quel que soit le mode de réalisation ou la variante, la première phase de préparage P1 peut comprendre notamment :
- une première étape E11 de mise à disposition d'une ébauche de saphir, notamment d'une boule de saphir (obtenue notamment par procédé Verneuil) ou d'une plaque de saphir (notamment obtenue par procédé EFG).
- une deuxième étape E12 de sciage de l'ébauche, notamment de la boule ou de la plaque, de façon à obtenir des rondelles préfigurant des ébauches de glace.
- des troisième et quatrième étapes E13, E14, respectivement de rodage et d'arrondissage, permettant de parvenir à des ébauches de glace dont les surfaces inférieure et supérieure sont planes et/ou parallèles, et formant des ébauches cylindriques.

L'étape de traitement thermique TT3 comprend, par exemple, un palier de température à environ 1050°C, notamment entre 1000°C et 1200°C, et peut éventuellement intervenir à l'issue de la première phase P1.

Quel que soit le mode de réalisation ou la variante, la deuxième phase d'usinage P2 peut comprendre ensuite différentes étapes permettant d'aboutir à la géométrie définitive de glace. Cette deuxième phase P2 comprend notamment une étape E21 de rectification ou de meulage formant le pourtour ou le bord latéral 100d de la glace. Cette étape E21 peut notamment comprendre une sous-étape ou différentes sous-étapes permettant d'obtenir la gorge annulaire ou la rainure 1c, et la creusure 1d dans le cas de figure spécifique d'un procédé de fabrication d'une glace creusée. Une autre étape E22 permet de former les biseaux ou les anglages de la glace. Une étape E23 de feutrage et de patinage de la creusure peut également être prévue afin de parvenir à la mise à dimension de la creusure 1d.

L'étape de traitement thermique TT2 comprend, par exemple, un palier de température à environ 1050°C, notamment entre 1000°C et 1200°C, et peut éventuellement intervenir entre ces différentes étapes ou sous-étapes de la deuxième phase d'usinage P2.

Selon le deuxième mode d'exécution du procédé, une étape de traitement thermique TT1, comprenant un palier de température à environ 1050°C, notamment entre 1000°C et 1200°C, peut intervenir entre les deuxième et troisième phases P2, P3. Dans le premier mode d'exécution du procédé, cette étape n'existe pas, mais la première étape TT1' comprenant un palier de température supérieur à 1100°C, notamment compris entre 1600°C et 2000°C, est mise en œuvre. La première étape TT1' de traitement thermique de détente peut notamment être effectuée :
- à une température supérieure à 1600°C, et/ou
- à une température inférieure à 2000°C ou inférieure à 1950°C ou inférieure à 1800°C ou inférieure à 1750°C.

Quel que soit le mode de réalisation ou la variante, la troisième phase de terminaison P3 peut comprendre différentes étapes de brossage ou de polissage, qu'il s'agisse de polissage chimique ou de polissage mécanique. À titre d'exemple, cette troisième phase peut comprendre une première étape de brossage E31 prévue pour arrondir les arêtes des biseaux ou des anglages. Différentes étapes E32 de brossage ou de polissage peuvent être prévues pour parvenir aux états de surface souhaités pour chacune des surfaces de la glace. Il peut s'agir d'étapes de polissage mécanique ou de brossage mécanique ou de brossage chimique.

Selon le deuxième mode d'exécution du procédé, une étape de traitement thermique TT1', comprenant notamment un palier de température compris entre 1600°C et 2000°C, peut intervenir entre deux étapes E31 et E32.

Quel que soit le mode d'exécution ou la variante, le procédé de fabrication permet avantageusement de réaliser une glace en saphir, notamment une glace en saphir non-coloré à savoir une glace ne subissant pas d'étape exclusivement dédiée à sa coloration, comme le montre les études expérimentales de la Déposante. Par ailleurs, quel que soit le mode d'exécution ou la variante, le procédé concerne toute glace en saphir non-coloré, quelle que soit son orientation cristallographique (A ou C) et quel que soit son procédé d'obtention préalable (procédé Verneuil, EFG, ou Kyropoulos). L'orientation du saphir peut être de type A, c'est-à-dire que l'axe optique est dans le plan de la glace ou pouvant s'écarter jusqu'à 15° du plan de la glace. Pour la mise en œuvre d'un procédé Verneuil, une telle orientation de saphir est privilégiée. En alternative, l'orientation du saphir peut être de type C, c'est-à-dire que l'axe optique est normal ou sensiblement normal au plan de la glace. Pour une telle orientation de saphir, les procédés de croissance Kyropoulos et EFG sont privilégiés.

Quel que soit le mode d'exécution ou la variante, la glace est de préférence cylindrique ou circulaire, mais le procédé peut être appliqué à toute autre géométrie de glace, comme une glace parallélépipédique ou rectangulaire.

Le procédé de fabrication est particulièrement indiqué pour l'obtention d'une glace creusée présentant des caractéristiques mécaniques optimisées.

Quel que soit le mode d'exécution ou la variante, une ou plusieurs ou toutes les étapes de traitement thermique de détente peuvent comprendre un palier d'une durée de plusieurs heures, par exemple entre 2 heures et 15 heures, typiquement 5 heures.

Quel que soit le mode d'exécution ou la variante, une ou plusieurs ou toutes les étapes de traitement thermique de détente peuvent être réalisées sous atmosphère contrôlée, notamment :
- sous vide, ou
- sous gaz neutre ou inerte, ou
- sous atmosphère réductrice, avec par exemple un gaz réducteur tel qu'un mélange H2-N2, ou avec par exemple un gaz neutre ou inerte combiné à des éléments chauffants en graphite qui vont produire du monoxyde de carbone, ou
- sous atmosphère oxydante, par exemple sous air.

Comme indiqué précédemment, les études menées par la Déposante ont montré que l'étape ou les étapes de traitement thermique de détente augmentent les propriétés mécaniques des glaces.

Les modes d'exécution et les variantes du procédé objet de l'invention, et en particulier les procédés décrits précédemment, peuvent permettre de réaliser des éléments horlogers 100 comme ceux qui sont décrits plus en détail ci-après. Ces éléments horlogers 100 peuvent aussi être obtenus par tout autre procédé.

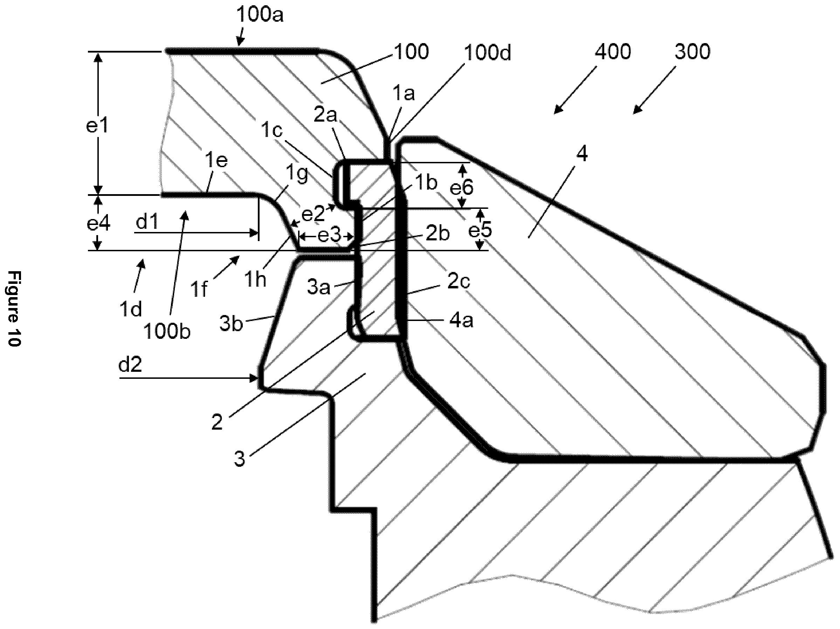

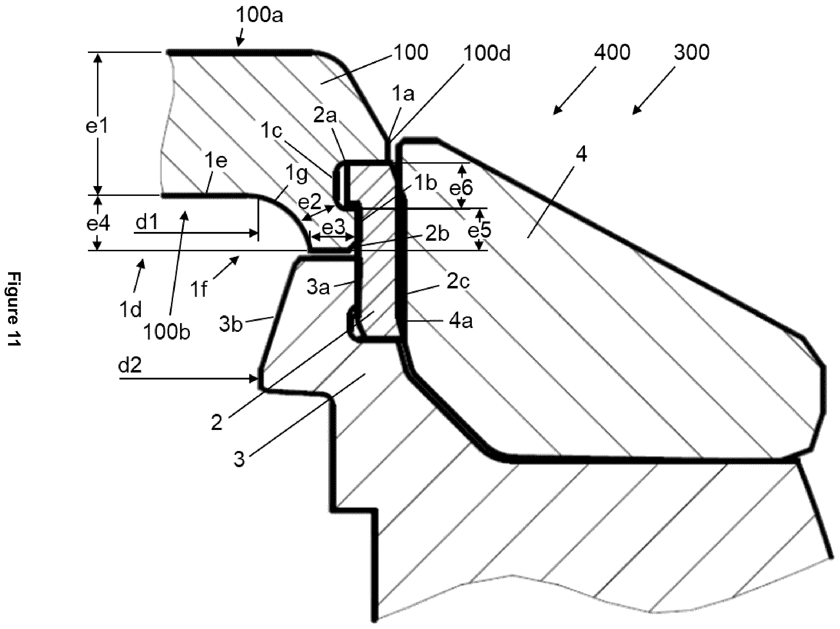

Dans les modes de réalisation décrits ci-après plus en détail en référence aux figures 10 et 11, la boîte de montre 400 comprend une glace 100, un joint d'étanchéité 2, une carrure 3 et une lunette 4. La glace 100 est usinée dans une plaque qui, de préférence, est réalisée dans un matériau dur tel que du verre trempé ou, avantageusement, du saphir ou plus généralement une céramique transparente. La glace comprend :
- un côté extérieur 100a destiné à être au contact de l'environnement extérieur,
- un côté intérieur 100b destiné à être au contact du volume interne de la boîte de pièce d'horlogerie, et
- un bord latéral 100d reliant les côtés extérieur et intérieur.

Le bord latéral 100d comprend une rainure 1c. Le côté intérieur comprend une creusure 1d de sorte que le bord 100d comprend une jupe 1f. La glace 100 présente ainsi une jupe 1f qui se trouve à l'interface de la creusure 1d et du bord latéral 100d de la glace. La creusure 1d peut présenter un fond de creusure 1e avec une géométrie plane, sensiblement plane, concave ou sensiblement concave. De préférence, depuis le fond de creusure 1e, la creusure 1d présente une portion 1h évasée, notamment sensiblement tronconique, au niveau de la jupe 1f. Autrement dit, la portion 1h comprend de préférence des flancs sensiblement inclinés relativement au fond de creusure 1e. La transition entre le fond de creusure 1e et la portion 1h présente un congé 1g. De préférence encore, le fond de creusure 1e de la creusure présente une dimension, notamment un diamètre d1, mesurée à la base du congé 1g, sensiblement égale ou supérieure à la dimension, notamment au diamètre, d'ouverture d2 de la carrure 3, au niveau notamment d'un rehaut 3b. Autrement dit, la plus grande surface s'inscrivant dans la dimension d'ouverture d2 est préférentiellement inférieure à la surface du fond de creusure 1e de la creusure. Autrement dit, la plus grande surface s'inscrivant dans la dimension d'ouverture d2 peut s'inscrire sur la surface formée par le fond de creusure 1e ou sur une projection de la surface formée par ce fond de creusure 1e sur un plan parallèle à l'une et/ou l'autre de ces surfaces. Cela permet d'optimiser la lisibilité du cadran et de l'aiguillage, en évitant toute déformation visuelle du cadran susceptible d'être induite par la géométrie de la jupe 1f au travers de la glace 100.

Dans le cas où le rehaut est porté par le cadran, le diamètre d'ouverture d2 correspond au diamètre interne à la base du rehaut de cadran.

Alternativement, la portion 1h peut présenter des flancs sensiblement droits ou perpendiculaires relativement au fond de creusure 1e, notamment sensiblement cylindriques. Alternativement encore, la creusure 1d peut ne pas comprendre de portion 1h, mais seulement un congé 1g. Préférentiellement, une projection de la surface formée par ce congé 1g sur un plan parallèle au cadran s'inscrit dans la projection de la surface du rehaut 3b sur ce même plan ou à l'extérieur de la projection de la surface du rehaut 3b sur ce même plan de sorte que la projection selon l'axe A1 de la surface du congé 1g ne recouvre pas la zone visible du cadran.

Dans le mode de réalisation décrit ci-après plus en détail en référence à la figure 10, la glace 100 comprend, sur le bord latéral 100d, deux portions de différentes dimensions, notamment de différents diamètres. Une portion 1a de grande dimension, notamment de grand diamètre est disposée du côté extérieur de la boîte de montre et une portion 1b, de plus petite dimension, notamment de plus petit diamètre, est disposée du côté intérieur de la boîte une fois la glace montée sur la boîte. Une gorge 1c ou une rainure 1c, notamment une gorge annulaire 1c, sépare lesdites portions 1a et 1b.

Le joint d'étanchéité 2 présente une forme adaptée à la périphérie de la glace 100, notamment une forme annulaire. La section longitudinale du joint relativement à l'axe A1 comprend une zone s'étendant vers l'axe A1. Cette portion forme une saillie 2a. Le joint 2 comprend une surface interne 2b destinée à coopérer avec la glace 100 et la carrure 3, ainsi qu'une surface externe 2c destinée à coopérer avec la lunette 4. Plus particulièrement, la surface interne 2b coopère par chassage avec la portion 1b de la glace 100 et avec une surface latérale externe 3a de la carrure 3 qui se situe sensiblement au même niveau que le rehaut 3b de la carrure 3. La surface externe 2c coopère par chassage avec une surface latérale interne 4a de la lunette 4. Ainsi, le bord latéral 100d comprend :
- du premier côté de la rainure annulaire 1c, la première portion 1b destinée à coopérer avec le joint d'étanchéité 2, et
- du deuxième côté de la rainure annulaire 1c, la deuxième portion 1a, d'une plus grande dimension, notamment d'un plus grand diamètre, que celle de la première portion 1b.

Le chassage de la lunette 4 sur le joint d'étanchéité 2 permet, de comprimer radialement ce dernier à l'encontre de la glace 100 et de la carrure 3, garantissant ainsi une tenue et étanchéité optimales de l'ensemble.

De préférence, la dimension de la portion 1a, notamment le diamètre de la portion 1a de la glace est très légèrement inférieur à la dimension de la surface externe 2c du joint, notamment au diamètre de la surface externe 2c du joint, de manière que ce dernier soit en grande partie dissimulé ou recouvert par la glace (vu perpendiculairement à la glace depuis l'extérieur). Il en résulte ainsi un interstice réduit entre la glace 100 et la lunette 4, entre la portion 1a et la surface latérale interne 4a. De ce fait, l'encombrement de la lunette 4 est avantageusement réduit, car il n'est pas nécessaire que la lunette passe par-dessus (selon un axe parallèle à l'épaisseur de la boîte) le joint d'étanchéité 2 pour le cacher.

En outre, le joint d'étanchéité 2 comprend la saillie 2a, notamment une saillie 2a annulaire, destinée à prendre place au sein de la gorge ou de la rainure 1c de la glace. Cette saillie 2a s'étend avantageusement radialement vers l'intérieur relativement à l'axe A1. Cette conformation permet avantageusement de réaliser un ancrage de la glace 100 sur le joint d'étanchéité 2 et de garantir ainsi une meilleure tenue de cette dernière au déchassage, pour un même effort radial donné à l'encontre de la jupe 1f, par exemple lorsque l'intérieur de la boîte est soumis à une pression plus élevée que l'extérieur. La glace 100 se trouve ainsi avantageusement maintenue par le joint d'étanchéité 2 par frottement et par ancrage ou obstacle. Ainsi, la rainure 1c coopère avec la saillie 2a du joint d'étanchéité 2 de façon à ancrer la glace 100, notamment à la lunette 4 et/ou à la carrure 3.

Grâce à la tenue optimisée rendue possible par l'ancrage de la glace 100 sur le joint 2, il est avantageusement possible d'obtenir une épaisseur e2 de toile matière très faible entre la gorge ou la rainure 1c et la creusure 1d, et un rayon de congé 1g très faible, sans compromettre la résistance mécanique de la glace 100. En effet, pour une même tenue de la glace au déchassage, l'ancrage permet de limiter les efforts radiaux liés à l'assemblage, et permet donc de minimiser l'épaisseur e2 de cette toile matière et le rayon minimal du congé 1g. Par exemple, ce congé 1g peut être de l'ordre de seulement 0.1 mm, et l'épaisseur e2 peut être de l'ordre de seulement 0.4 mm. La portion 1h est de préférence évasée de sorte à présenter des flancs sensiblement inclinés relativement au fond de creusure 1e, notamment une portion de surface tronconique, permettant de limiter les concentrations de contraintes au niveau de la jupe 1f. Ces dimensions peuvent être notamment atteintes pour des boîtes de montre dimensionnées de façon à résister aux chocs accidentels selon la norme ISO 1413, NIHS 91-10 et pour être étanches à au moins 100 mètres, soit à une pression d'au moins 10 bars. Par conséquent, la jupe 1f peut également présenter une section avec une épaisseur e3 de toile matière, mesurée entre la portion 1b et la creusure 1d, avantageusement plus faible que l'épaisseur e1 de la glace, mesurée entre le côté extérieur de la glace et le fond de la creusure 1d, c'est-à-dire e3/e1 <1.

De plus, grâce à l'ancrage précédemment décrit, la creusure 1d permet de réduire davantage l'encombrement de la boîte de montre. En effet, cette solution permet avantageusement d'atteindre une épaisseur minimale e1 au centre de la glace 100, définie par des calculs de résistance des matériaux, sans modifier l'esthétique de la boîte de montre du côté glace. De ce fait, l'aiguillage du mouvement peut avantageusement prendre place, du moins en partie, au sein de la creusure 1d. Cela permet donc de décaler le mouvement du côté de la glace et de réduire encore davantage l'épaisseur de la boîte de montre du côté fond. Avantageusement, l'ancrage et l'étanchéité de la glace 100 sont déportés le plus possible à l'intérieur de la boîte, de sorte à déporter également l'assemblage de la lunette 4 vers l'intérieur et amincir l'épaisseur de la boîte de montre. De ce fait, l'épaisseur e5 de matière entre l'extrémité de la jupe 1f, au niveau de la portion 1b, et la gorge ou la rainure 1c est avantageusement plus faible que la profondeur e4 de la creusure 1d. Par conséquent, le rapport e5 sur e4 peut avantageusement être inférieur à 1, c'est-à-dire e5/e4<1.

Dans le mode de réalisation illustré par la figure 10, la glace 100 est dimensionnée pour supporter une immersion dans l'eau à une profondeur de 100 m, avec une épaisseur e1 de 1.3 mm et une creusure 1d d'une profondeur e4 de 0.5 mm. La toile matière entre la gorge ou la rainure 1c et la creusure 1d est d'une épaisseur e2 de 0.49 mm. L'épaisseur e3 de la section de la jupe 1f est de 0.55 mm avec un congé 1g d'un rayon de 0.3 mm. Le rapport e3 sur e1 est égal à 0.42. L'épaisseur e5 est de 0.38 mm. Par conséquent, le rapport e5 sur e4 est égal à 0.76.

Dans le mode de réalisation illustré par la figure 11, la glace 100 est dimensionnée pour supporter une immersion dans l'eau à une profondeur de 100 m, avec une épaisseur e1 de glace de 1.3 mm et une creusure 1d d'une profondeur e4 de 0.5 mm. La toile matière entre la gorge ou la rainure 1c et la creusure 1d est d'une épaisseur e2 de 0.390 mm. L'épaisseur e3 de la section de la jupe 1f est de 0.45 mm avec un congé 1g d'un rayon de 0.6 mm. Le rapport e3 sur e1 est égal à 0.35. L'épaisseur e5 est de 0.38 mm. Par conséquent, le rapport e5 sur e4 est égal à 0.76. À la différence du mode de réalisation illustré par la figure 10, la jupe 1f ne comprend pas de portion 1h tronconique.

Les deux modes de réalisations décrits comprennent une glace avec une surface extérieure plane. Toutefois, quel que soit le mode de réalisation ou la variante, la solution est également applicable à une glace présentant une surface extérieure bombée. Il en va de même pour le fond de la creusure qui peut aussi présenter une surface concave ou bombée.

Quel que soit le mode de réalisation ou la variante, le congé 1g peut être confondu avec le fond de creusure 1e de la creusure 1d qui comprend alors une surface concave ou sensiblement concave qui s'étend du centre jusqu'au bord de la glace 100.

Quel que soit le mode de réalisation ou la variante, de préférence, le joint d'étanchéité 2 est réalisé :
- en nylon ou polyamide, tel qu'un polyamide 6 ou 6.6 ou un Zytel^{®} ou un Grilamid^{®}, ou
- en élastomère thermoplastique ou en copolyester élastomère thermoplastique tel que l'Hytrel^{®}.

L'élément horloger 100 décrit en référence aux figures 1, 3, 10 et 11 est une glace prévue pour laisser apparaître un cadran ou plus généralement tout dispositif d'affichage d'une pièce d'horlogerie. Toutefois, quel que soit le mode de réalisation ou la variante, l'élément horloger 100 peut être une glace de fond, c'est-à-dire une glace laissant apparaître un mouvement horloger ou tout mécanisme d'un mouvement horloger. Cette glace peut être rapportée directement sur une carrure ou sur tout élément intermédiaire susceptible d'être rapporté sur la carrure. Ainsi, une glace de fond peut être rapporté sur un fond présentant par exemple la forme d'un élément annulaire pouvant être rapporté sur la carrure.

L'élément horloger 100 décrit en référence aux figures 1, 3, 10 et 11 est circulaire. Toutefois, quel que soit le mode de réalisation ou la variante, l'élément horloger 100 peut être non-circulaire, il peut notamment présenter une forme de tonneau ou une forme sensiblement rectangulaire ou une forme sensiblement carrée. En conséquence, la rainure 1c présente une géométrie similaire circulaire ou non-circulaire.

Quel que soit le mode de réalisation ou la variante, l'élément horloger 100 peut comprendre une rainure 1c sur toute sa périphérie ou il peut comprendre une rainure 1c sur plusieurs portions limitées angulairement en étendue autour de l'axe A1 , soit plusieurs logements. Ces portions ou logements sont de préférence :
- répartis régulièrement autour de l'axe A1, et/ou
- susceptibles de coopérer avec autant de saillies internes du joint d'étanchéité 2.

Quel que soit le mode de réalisation ou la variante, l'élément horloger 100 est de préférence dimensionné pour résister à une pression d'au moins 10 bars appliquée sur le côté extérieur (étanchéité à 100 m), notamment 20 bars (étanchéité à 200 m) ou 30 bars (étanchéité à 300 m).

Quel que soit le mode de réalisation ou la variante, la première épaisseur e1 mesurée entre le côté extérieur et le fond de la creusure peut être comprise entre 1 mm et 1.5 mm ou valoir typiquement environ 1.3 mm.

Quel que soit le mode de réalisation ou la variante, la deuxième épaisseur e2 mesurée entre le fond de la rainure et un flanc de la creusure peut être comprise entre 0.35 mm et 0.5 mm.

Quel que soit le mode de réalisation ou la variante, la troisième épaisseur e3 de la jupe mesurée entre la portion 1b et la creusure 1d peut être comprise entre 0.4 mm et 0.6 mm.

Quel que soit le mode de réalisation ou la variante, le rapport de la troisième épaisseur e3 sur la première épaisseur e1 peut être inférieur à 1, voire compris entre 0.3 et 0.5, ou valoir typiquement 0.35 ou 0.42.

Quel que soit le mode de réalisation ou la variante, la profondeur e4 de la creusure 1d peut être comprise entre 0.2 mm et 0.6 mm.

Quel que soit le mode de réalisation ou la variante, l'épaisseur e5 de la première portion 1b peut être comprise entre 0.3 mm et 0.4 mm, ou valoir typiquement 0.38 mm.

Quel que soit le mode de réalisation ou la variante, le rapport de l'épaisseur e5 sur la profondeur e4 de la creusure 1d peut être inférieur à 1, voire compris entre 0.7 et 0.8, ou valoir typiquement 0.76. Toutefois, dans le cas de figure dans lequel la profondeur e4 est particulièrement faible, de l'ordre de 0.2 ou 0.3, ce rapport d'épaisseur peut être supérieur à 1.

Quel que soit le mode de réalisation ou la variante, le congé de raccordement 1g peut présenter un rayon compris entre 0.1 mm et 0.7 mm, ou valoir typiquement 0.3 mm ou 0.6 mm.

Quel que soit le mode de réalisation ou la variante, le joint d'étanchéité 2 est de préférence disposé entre la lunette et l'élément horloger 100.

Quel que soit le mode de réalisation ou la variante, la largeur e6 de la rainure, mesurée parallèlement à l'axe A1, peut être comprise entre 0.2 mm et 0.5 mm.

Grâce aux solutions objets de l'invention, à la différence des solutions de l'art antérieur, on peut réaliser une boîte de montre dont l'épaisseur est réduite avec, par exemple, un joint d'étanchéité caché par une glace ou une lunette qui le surplombe, et sans déformation visuelle.

Grâce aux procédés objets de l'invention, on obtient des glaces résistantes aux chocs, en particulier présentant des caractéristiques de résistances supérieures aux spécifications très exigeantes de la déposante. Ceci permet de réaliser une glace saphir creusée et amincie.

## Revendications

1. Procédé de fabrication d'un élément horloger en saphir (100), le procédé comprenant une phase d'usinage, puis une phase de terminaison,
le procédé comprenant en outre une première étape de traitement thermique de détente comprenant un premier palier à une première température supérieure à 1100°C après la phase d'usinage.

2. Procédé de fabrication selon la revendication 1, **caractérisé** :
- **en ce que** la première température est supérieure à 1600°C, et/ou
- **en ce que** la première température est inférieure à 2000°C ou inférieure à 1950°C ou inférieure à 1800°C ou inférieure à 1750°C.

3. Procédé de fabrication selon l'une des revendications précédentes, **caractérisé en ce que** la première étape de traitement thermique de détente a lieu entre les phases d'usinage et de terminaison.

4. Procédé de fabrication selon l'une des revendications 1 et 2, **caractérisé en ce que** la première étape de traitement thermique de détente a lieu entre deux étapes de polissage successives de la phase de terminaison.

5. Procédé de fabrication selon l'une des revendications précédentes, **caractérisé en ce que** le procédé de fabrication comprend une deuxième étape de traitement thermique de détente, comprenant un palier à une température comprise entre 1000°C et 1200°C, notamment à une température d'environ 1050°C.

6. Procédé de fabrication selon la revendication précédente, **caractérisé en ce que** la deuxième étape de traitement thermique de détente, a lieu entre les phases d'usinage et de terminaison.

7. Procédé de fabrication selon l'une des revendications précédentes, **caractérisé en ce que** le procédé de fabrication comprend une troisième étape de traitement thermique de détente, comprenant un palier à une température comprise entre 1000°C et 1200°C, notamment à une température d'environ 1050°C, ayant lieu entre deux étapes d'usinage successives de la phase d'usinage.

8. Procédé de fabrication selon l'une des revendications précédentes, **caractérisé en ce que** le procédé de fabrication comprend :
- une phase de préparage antérieure à la phase d'usinage, et
- une quatrième étape de traitement thermique de détente, comprenant un palier à une température comprise entre 1000°C et 1200°C, notamment à une température d'environ 1050°C, ayant lieu entre la phase de préparage et la phase d'usinage.

9. Procédé de fabrication selon l'une des revendications précédentes, **caractérisé en ce que** le premier palier à la première température a une durée comprise entre 2 heures et 15 heures, typiquement 5 heures.

10. Procédé de fabrication selon l'une des revendications précédentes, **caractérisé en ce qu'**une ou plusieurs ou toutes les deuxième, troisième et quatrième étapes comprend ou comprennent un palier à une température d'environ 1050°C, le palier ayant une durée comprise entre 2 heures et 15 heures, typiquement 5 heures.

11. Procédé de fabrication selon l'une des revendications précédentes, **caractérisé en ce qu'**une ou plusieurs ou toutes les première, deuxième, troisième et quatrième étapes sont réalisées sous atmosphère contrôlée, notamment :
- sous vide, ou
- sous gaz neutre ou inerte, ou
- sous atmosphère réductrice ou désoxydante, ou
- sous atmosphère oxydante, par exemple sous air.

12. Procédé de fabrication selon l'une des revendications précédentes, **caractérisé en ce que** l'élément horloger (100) est une glace et la phase d'usinage comprend la réalisation d'une creusure dans la glace et/ou **en ce que** l'élément horloger (100) est réalisé en saphir incolore ou en saphir non-coloré.

13. Procédé de fabrication selon l'une des revendications 1 à 11, **caractérisé en ce que** l'élément horloger est un élément d'habillage ou élément de mouvement horloger, en particulier :
- une glace, notamment prévue pour être rapportée sur une carrure ou sur un fond, ou
- un fond, ou
- une couronne, ou
- une lunette, ou
- un disque de lunette, ou
- une carrure, ou
- une carrure incluant une glace, notamment la carrure formant une glace ou la carrure étant formée d'un seul tenant avec la glace, ou
- un disque indicateur, notamment un disque de calendrier.

14. Elément horloger en saphir (100), notamment en saphir incolore ou en saphir non-coloré, obtenu par la mise en œuvre du procédé de fabrication selon l'une des revendications précédentes.

15. Boîte de pièce d'horlogerie (400) comprenant un élément horloger en saphir (100) selon la revendication précédente.

16. Pièce d'horlogerie (300), notamment montre-bracelet, comprenant :
- un élément horloger en saphir (100) selon la revendication 14, et/ou
- une boîte de pièce d'horlogerie (400) selon la revendication précédente.
